# EUROPEAN PATENT APPLICATION

(11) **EP 4 600 328 A1**
(43) Date of publication of application: **13.08.2025**
(21) Application number: 23884070.6
(22) Date of filing: 04.04.2023
(51) Int. Cl.: C10B 53/04, C10B 57/14, C10B 55/00, C30B 29/02, C30B 1/02, C01B 32/20, H01M 4/587, H01M 10/0525

(54) **MODIFIED GREEN COKE MATERIAL, PREPARATION METHOD THEREFOR, AND USE THEREOF**

(30) Priority: 04.11.2022 CN 202211378795
(71) Applicant: Hunan Zhongke Shinzoom Co., Ltd., Ningxiang Changsha, Hunan 410000 (CN)
(72) Inventor: HU, Kongming, Changsha, Hunan 410000 (CN); WANG, Zhiyong, Changsha, Hunan 410000 (CN); SHE, Yingqi, Changsha, Hunan 410000 (CN); ZHANG, Miao, Changsha, Hunan 410000 (CN)
(74) Representative: Ipside
(86) International application number: PCT/CN2023/086126
(87) International publication number: WO 2024/093127

(57) **Abstract**

The disclosure provides a modified green coke material, a method for preparing the modified green coke material, and an application of the modified green coke material. A sum of percentages of a long fibrous structure and a broad-domain structure in a polarized microstructure of the modified green coke material is in a range of 55 ~ 99%, and a percentage of volatile components in the modified green coke material is in a range of 1% ≤ volatile components matter < 5%. In regard to the modified green coke material provided in the disclosure, the long fibrous structure and the broad-domain structure are increased, the volatile components are effectively reduced, and light components are further excluded, thereby eliminating a self-bonding property of raw materials. In this case, further agglomeration will not occur during a subsequent heat treatment for preparing a graphite negative electrode material. Using the modified green coke material to prepare the graphite negative electrode material can effectively improve a graphitization degree, a gram capacity, and a compaction density of the graphite negative electrode material, thus comprehensively improving the performance of the graphite negative electrode material.

## Description

### TECHNICAL FIELD

Embodiments of the disclosure relate to the technical field of raw materials for preparing graphite, in particular, to a modified green coke material, a method for preparing the modified green coke material, and an application of the modified green coke material.

### BACKGROUND

A negative electrode material, as one of the core components of the cell, plays a critical role in the comprehensive performance of the cell. Among different types of the relevant negative electrode materials, graphite materials are used as negative electrode materials for commercialized lithium ion cells by virtue of their advantages such as low charging-discharging platform, high theoretical lithium insertion capacity, and good electrical conductivity. A natural graphite has been widely used as a commercialized negative electrode material due to advantages such as high gram capacity, low price, and abundant natural resource. However, the natural graphite has disadvantages such as poor compatibility with an electrolyte, large first irreversible capacity, poor charge and discharge rate performance, and poor cycle performance, which directly affect the application of the natural graphite in a lithium ion cell with a long cycle life and a high rate performance. An artificial graphite, on the other hand, with advantages such as good compatibility with an electrolyte, good cycle performance, and good rate performance, has become a preferred negative electrode material for a power cell with a long cycle life and a high rate performance.

A raw green coke material is usually used as a raw material of a normal artificial graphite. However, a conventional raw green coke material has a structure that is not fully developed and has a relatively high content of residual light components, which has a negative impact on the graphitization of the conventional raw green coke material. In this case, graphite products made of conventional raw green coke material have a low graphitization degree, a low gram capacity, and a low compaction density, and thus the requirements of a graphite negative electrode material with a high energy density cannot be satisfied. The conventional raw green coke material has a high percentage of volatile components generally in a range of 4% ~ 15%. For those raw green coke materials with a high percentage of volatile components, an agglomeration or even a caking phenomenon is easy to occur during a heat treatment, thereby increasing the cost of subsequent processes of de-agglomeration and dispersing.

For example, CN109748274A discloses a method for preparing a low-cost composite granular graphite negative electrode material. This disclosure includes the following. A raw green coke material and a pitch powder at a mass ratio in a range of 100:1 ~ 100:20 are mixed to obtain a mixed material; the mixed material is put into a graphitization furnace to perform a graphitization treatment, so as to obtain a composite granular graphite material; the composite granular graphite material is graded to obtain a graded material; the graded material is screened and demagnetized to obtain a composite granular graphite negative electrode material. The raw green coke material in this disclosure is an uncalcined needle coke (green needle coke).

For another example, CN111354927A discloses a composite graphite negative electrode material, a lithium ion cell, a preparation method therefor, and an application thereof. The preparation method includes the following steps. At step S1, a mixture of an uncalcined coke powder, a flake graphite powder, a graphitization catalyst, and a graphitizable binder is prepared, where the uncalcined coke powder and the flake graphite powder is at a mass ratio in a range of 1:1.5 ~ 1:4, the amount of the graphitization catalyst is 0.1 ~ 0.8% of a sum of the mass of the uncalcined coke powder and the flake graphite powder, and the amount of the graphitizable binder is 1 ~ 9% of the sum of the mass of the uncalcined coke powder and the flake graphite powder. Step S2 is a carbonization treatment. Step S3 is a catalytic graphitization high-temperature treatment.

Graphite materials of the above disclosures are all made of raw green coke materials. In this case, to a certain extent, the requirements of the graphite negative electrode material with a high energy density cannot be satisfied, and thus a graphite negative electrode material with a good comprehensive electrochemical performance cannot be obtained.

Therefore, how to modify the raw green coke material so as to improve performances such as gram capacity, first-cycle efficiency, and compaction density of the graphite negative electrode material prepared from the raw green coke material, is a technical problem to be solved.

### SUMMARY

The following is a summary of the subject matter of the disclosure. This summary is not intended to limit the scope of the claims.

Embodiments of the disclosure provide a modified green coke material, a method for preparing the modified green coke material, and an application of the modified green coke material. In regard to the modified green coke material provided in the disclosure, a long fibrous structure and a broad-domain structure are increased, volatile components are effectively reduced, and light components are further excluded, thereby eliminating a self-bonding property of raw materials. In this case, further agglomeration will not occur during a subsequent heat treatment for preparing a graphite negative electrode material. Using the modified green coke material to prepare the graphite negative electrode material can effectively improve a graphitization degree, a gram capacity, and a compaction density of the graphite negative electrode material, thus comprehensively improving the performance of the graphite negative electrode material.

In a first aspect, the modified green coke material is provided in embodiments of the disclosure. A sum of percentages of the long fibrous structure and the broad-domain structure in a polarized microstructure of the modified green coke material is in a range of 55 ~ 99%. A percentage of volatile components in the modified green coke material is in a range of 1% ≤ volatile components < 5%.

In regard to the modified green coke material provided in the disclosure, the long fibrous structure and the broad-domain structure are increased, the volatile components are effectively reduced, and the light components are further excluded, thereby eliminating the self-bonding property of raw materials. In this case, further agglomeration will not occur during the subsequent heat treatment for preparing the graphite negative electrode material. Using the modified green coke material to prepare the graphite negative electrode material can effectively improve the graphitization degree, the gram capacity, and the compaction density of the graphite negative electrode material, and can maintain a low-expansion performance and a good fast charge performance of a raw green coke material at the same time, thus comprehensively improving the performance of the graphite negative electrode material. However, if the percentage of the volatile components in the modified green coke material is too low, i.e., lower than 1%, the heat treatment may be excessive, which means the modified green coke material after heat treatment may possess features similar to a calcined coke (for example, small interlayer distance after graphitization). In this case, the graphite negative electrode material prepared subsequently is easy to expand during the charging and discharging process, which leads to a poor fast charge performance and a poor cycle life of the graphite negative electrode material. If the percentage of the volatile components in the modified green coke material is too high, i.e., higher than or equal to 5%, the heat treatment may be insufficient, which means the growth of green coke crystals is incomplete. In this case, the gram capacity and the compaction density of the graphite negative electrode material prepared subsequently are improved in a limited way.

For example, the percentage of the volatile components in the modified green coke material may be 1%, 1.3%, 1.5%, 1.8%, 2%, 2.3%, 2.5%, 2.8%, 3%, 3.3%, 3.5%, 3.8%, 4%, 4.3%, 4.5%, 4.8%, 4.9%, 4.95%, etc. The sum of percentages of the long fibrous structure and the broad-domain structure may be 55%, 58%, 60%, 63%, 65%, 68%, 70%, 73%, 75%, 78%, 80%, 83%, 85%, 88%, 90%, 93%, 95%, 98%, 99%, etc.

Preferably, a hardgrove grindability index (HGI) of the modified green coke material is in a range of 20 ~ 100. For example, the HGI may be 20, 25, 30, 35, 40, 45, 50, 55, 60, 65, 70, 75, 80, 85, 90, 95, 100, etc.

Preferably, the percentage of the volatile components in the modified green coke material is in a range of 2% ≤ volatile components < 5%. For example, the percentage of the volatile components may be 2%, 2.3%, 2.5%, 2.8%, 3%, 3.3%, 3.5%, 3.8%, 4%, 4.3%, 4.5%, 4.8%, 4.9%, 4.95%, etc.

In the disclosure, the percentage of the volatile components in the modified green coke material in a range of 2% ≤ volatile components < 5% is conducive to the growth of the long fibrous structure and the broad-domain structure of the modified green coke material. In this case, the gram capacity and the compaction density of the graphite negative electrode material obtained from a graphitized modified green coke material are effectively improved, at the same time, the low-expansion performance and the good fast charge performance of the raw green coke material are maintained.

Preferably, a true density of the modified green coke material is in a range of 1.4 ~ 2g/cm³. For example, the true density may be 1.4g/cm³, 1.41g/cm³, 1.42g/cm³, 1.43g/cm³, 1.44g/cm³, 1.45g/cm³, 1.46g/cm³, 1.47g/cm³, 1.48g/cm³, 1.49g/cm³, 1.5g/cm³, 1.6g/cm³, 1.7g/cm³, 1.8g/cm³, 1.9g/cm³, 2g/cm³, etc. The true density of the modified green coke material is preferred to be in a range of 1.4 ~ 1.5g/cm³.

In the case where the true density of the modified green coke material provided in the disclosure is in a range of 1.4 ~ 1.5g/cm³, the growth of the green coke crystals can be better realized. If the true density is greater than 1.5g/cm³, the graphite negative electrode material prepared subsequently is easy to expand during the charging and discharging process, which leads to a poor fast charge performance and a poor cycle life of the graphite negative electrode material prepared subsequently. However, a relatively small true density is not conducive to the growth of the green coke crystals, resulting in a low gram capacity and a low compaction density of the graphite negative electrode material.

In a second aspect, a method for preparing the modified green coke material is provided in embodiments of the disclosure. The method includes the following.

A treatment is performed on a raw green coke material to obtain green coke particles with D50 in a range of 0.1 ~ 0.5mm, and then a low-temperature heat treatment is performed to obtain the modified green coke material.

In the disclosure, a modification treatment is performed on the raw green coke material. By performing the low-temperature heat treatment on the green coke particles with D50 strictly in a range of 0.1 ~ 5mm, a short fibrous structure of the raw green coke material may further develop into the long fibrous structure. In this case, the sum of percentages of the long fibrous structure and the broad-domain structure in a polarized microstructure of the modified green coke material is increased, the volatile components are effectively reduced, and the light components are further excluded, thereby eliminating the self-bonding property of the raw materials and the agglomeration of particles occurred during the heat treatment. In this way, the graphitization degree, the gram capacity, and the compaction density of the graphite negative electrode material prepared from the modified green coke material are improved.

In the disclosure, if D50 of the green coke particles is greater than 5 mm, the volatile components may escape insufficiently and the growth of the green coke crystals may be incomplete during the low-temperature heat treatment. In this case, a modified green coke material with a sum of percentages of the long fibrous structure and the broad-domain structure in a range of 55 ~ 99% and a percentage of the volatile components in a range of 1% ≤ volatile components < 5% may be difficult to obtain. Likewise, if D50 is less than 0.1 mm, the growth of the green coke crystals during the low-temperature heat treatment may be hindered. In this case, the above modified green coke material is still difficult to obtain.

For example, D50 of the green coke particles may be 0.1mm, 0.3mm, 0.5mm, 0.8mm, 1mm, 1.3mm, 1.5mm, 1.8mm, 2mm, 2.3mm, 2.5mm, 2.8mm, 3mm, 3.5mm, 3.8mm, 4mm, 4.3mm, 4.5mm, 4.8mm, 5mm, etc.

Preferably, the raw green coke material includes any one or at least two selected from green petroleum coke, green needle coke, green pitch coke, and mesophase coke.

Preferably, the treatment includes screening and/or crushing.

Preferably, D50 of the green coke particles is in a range of 0.3 ~ 3mm, for example, 0.3mm, 0.5mm, 0.8mm, 1mm, 1.2mm, 1.3mm, 1.5mm, 1.6mm, 1.8mm, 2mm, 2.2mm, 2.3mm, 2.5mm, 2.6mm, 2.8mm, 3mm, etc.

In the disclosure, in the case where D50 of the green coke particles is in a range of 0.3 ~ 3.0mm, the gram capacity and the compaction density of the graphite negative electrode material obtained from the graphitized modified green coke material can be effectively improved, and the low-expansion performance and the good fast charge performance of the raw green coke material can be maintained at the same time.

Preferably, the low-temperature heat treatment is performed at a temperature in a range of 500 ~ 900°C, for example, 530°C, 550°C, 580°C, 600°C, 630°C, 650°C, 680°C, 700°C, 730°C, 750°C, 780°C, 800°C, 830°C, 850°C, 880°C, 900°C, etc.

Preferably, the low-temperature heat treatment is performed for a period of 2 ~ 6h, for example, 2h, 3h, 4h, 5h, 6h, etc.

In the disclosure, if the temperature of the low-temperature heat treatment is too low and the period of the low-temperature heat treatment is too short, the growth of the green coke crystals and the escape of the volatile components may not be well achieved, resulting in that the gram capacity and the compaction density of the graphite negative electrode material obtained from the graphitized modified green coke material cannot be effectively improved. However, if the temperature of the low-temperature heat treatment is too high and the period of the low-temperature heat treatment is too long, the graphite negative electrode material prepared subsequently is likely to expand during the charging and discharging process, which leads to a poor fast charge performance and a poor cycle life of the graphite negative electrode material.

That is, in the disclosure, by adjusting and controlling the temperature of the low-temperature heat treatment, the period of the low-temperature heat treatment, and D50 of the green coke particles, the modified green coke material with a sum of percentages of the long fibrous structure and the broad-domain structure in a range of 55 ~ 99% and a percentage of the volatile components in a range of 1% ≤ volatile components < 5% is prepared. The graphite negative electrode material obtained from the graphitized modified green coke material maintains the low-expansion performance and the good fast charge performance of the raw green coke material. At the same time, the graphitization degree, the gram capacity, and the compaction density of the graphite negative electrode material are significantly improved.

Preferably, during the low-temperature heat treatment, the oxygen content ≤ 500ppm. For example, the oxygen content may be 500ppm, 450ppm, 400ppm, 350ppm, 300ppm, 250ppm, 200ppm, 150ppm, 100ppm, 50ppm, 0ppm, etc.

During the low-temperature heat treatment of the disclosure, if the oxygen content is too high, a burning loss of materials will be relatively high, or a safety hazard may even arise, which is not conducive to a further graphitization of the modified green coke material.

As a preferred technical solution, the method includes the following.

The raw green coke material is crushed to obtain the green coke particles with D50 in a range of 0.1 ~ 5mm, and a low-temperature heat treatment is performed at a temperature of 500 ~ 900°C for 2 ~ 6h to obtain the modified green coke material.

In a third aspect, the graphite negative electrode material is provided in embodiments of the disclosure. The graphite negative electrode material is obtained after graphitization of the modified green coke material in the first aspect.

The methods for preparing the graphite negative electrode material provided in the disclosure are all conventional technical solutions, which can be achieved in the related art. The disclosure is applicable to methods using the raw green coke material as one of the raw materials. That is, the modified green coke material provided in the disclosure may be the only raw material for preparing the graphite negative electrode material, or may be one of the raw materials for preparing the graphite negative electrode material.

Exemplarily, the disclosure provides a method for preparing the graphite negative electrode material using the modified green coke material provided in the disclosure.
(1) The modified green coke material is crushed to obtain a crushed modified green coke material with D50 in a range of 8 ~ 20µm.
(2) A graphitization treatment is performed on the crushed modified green coke material at a temperature in a range of 2500 ~ 3500°C.

At operation (2), before/after the graphitization treatment, a further treatment such as grading, modifying, coating, and granulating may be performed.

In a fourth aspect, a lithium-ion cell is provided in embodiments of the disclosure. The lithium-ion cell includes the graphite negative electrode material provided in the third aspect.

Compared with the related art, embodiments of the disclosure possess the following beneficial effect.

First, in regard to the modified green coke material provided in the disclosure, the long fibrous structure and the broad-domain structure are increased, the volatile components are effectively reduced, and the light components are further excluded, thereby eliminating the self-bonding property of the raw materials. In this case, further agglomeration will not occur during the subsequent heat treatment for preparing the graphite negative electrode material. Using the modified green coke material to prepare the graphite negative electrode material can effectively improve the graphitization degree, the gram capacity, and the compaction density of the graphite negative electrode material, thus comprehensively improving the performance of the graphite negative electrode material. In the disclosure, by adjusting D50 of the green coke particles, the temperature of the low-temperature heat treatment, and the period of the low-temperature heat treatment in a preparing process, a modified green coke material with a percentage of the volatile components in a range of 1% ≤ volatile components < 5% and a true density in a range of 1.4 ~ 2g/cm³ is obtained. A cell using the graphite negative electrode material prepared from the modified green coke material as a negative electrode has a gram capacity greater than 352.1mAh/g at 1C and a charging windows above 1-5C, which is indicated by the absence of lithium precipitation at the negative electrode of the cell charged to 100% state of charge (SOC) at different rates (1C, 2C, 3C, 4C, 5C, 6C).

Second, in the method provided in the embodiments of the disclosure, a modified green coke material with excellent performances is obtained by strictly controlling D50 of the green coke particles, the temperature of the heat treatment, and the period of the heat treatment in a modification process. The method is easy to operate without a complex process, and is suitable for large-scale production.

Other aspects of the disclosure may be understood after reading and comprehending accompany drawings and detailed description in the following.

### BRIEF DESCRIPTION OF THE DRAWINGS

The accompanying drawings are used to provide a further understanding of the technical solution of the disclosure and form a part of the specification. The accompanying drawings are used to explain the technical solution together with the embodiments of the disclosure and do not constitute a limitation on the technical solution of the disclosure.
FIG. 1 is a polarized micrograph of a modified petroleum coke material provided in example 1.
FIG. 2 is a polarized micrograph of a raw petroleum coke material (unmodified) provided in comparative example 1.

### DETAILED DESCRIPTION

Technical solution of the disclosure will be further described through the following specific embodiments. Those of ordinary skills in the art should understand that the embodiments are only used to help understanding of the disclosure and should not be considered as a limitation to the disclosure.

In a specific embodiment, a method for preparing a modified green coke material is provided. The method includes the following.

A raw green coke material is crushed to obtain green coke particles with D50 in a range of 0.1 ~ 5mm, and then a low-temperature heat treatment is performed at a temperature of 500 ~ 900°C for 2 ~ 6h in an environment with an oxygen content ≤ 500ppm to obtain the modified green coke material.

The raw green coke material includes any one or at least two selected from green petroleum coke, green needle coke, green pitch coke, and mesophase coke.

### Examples 1-4

A modified petroleum coke material is provided in examples 1-4. Volatile components, a hardgrove grindability index (HGI), a true density, and a sum of percentages of a long fibrous structure and a broad-domain structure in a polarized microstructure of the modified petroleum coke material are as illustrated in Table 1.

A method for preparing the modified petroleum coke material is also provided in examples 1-4. According to the method provided in detailed description, an oxygen content in the low-temperature heat treatment is less than 500ppm and a percentage of the volatile components in a raw petroleum coke material is 10%. Other parameters are as illustrated in Table 1.

### Comparative example 1

In comparative example 1, no treatment will be performed on the raw petroleum coke material.

### Comparative examples 2-6

A modified petroleum coke material is provided in comparative examples 2-6. Volatile components, an HGI, a true density, and a sum of percentages of a long fibrous structure and a broad-domain structure in a polarized microstructure of the modified petroleum coke material are as illustrated in Table 1.

A method for preparing the modified petroleum coke material is also provided in comparative examples 2-6. According to the method provided in detailed description, the oxygen content in the low-temperature heat treatment is less than 500ppm and the percentage of the volatile components in the raw petroleum coke material is 10%. Other parameters are as illustrated in Table 1.

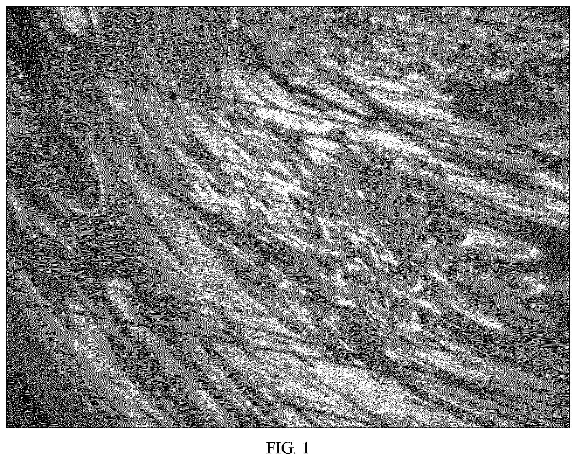

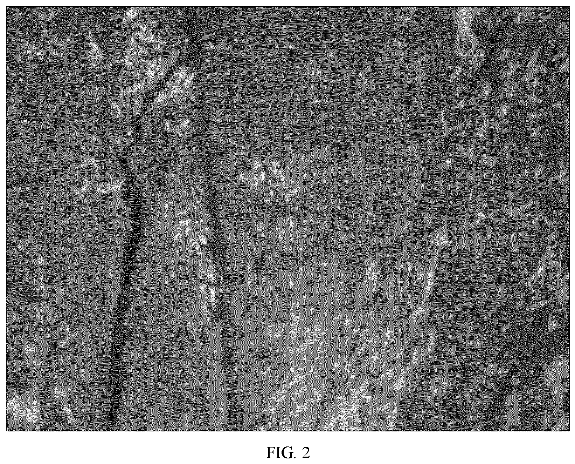

FIG. 1 is a polarized micrograph of a modified petroleum coke material provided in example 1. FIG. 2 is a polarized micrograph of a raw petroleum coke material (unmodified) provided in comparative example 1. Comparing FIG. 1 with FIG. 2, it may be seen that the long fibrous structure and the broad-domain structure of the modified petroleum coke material are effectively increased after the low-temperature heat treatment. According to the percentage of the long fibrous structure and the percentage of the broad-domain structure in the polarized micrograph, it may be understood that the sum of percentages of the long fibrous structure and the broad-domain structure of the modified petroleum coke material is in a range of 55 ~ 99%.

**Table 1**

| Petroleum coke | Preparation parameter | | | Modified petroleum coke | | | |
|---|---|---|---|---|---|---|---|
| | D50 of the green coke particles (mm) | Temperature of the heat treatment (°C) | Period of the heat treatment (h) | Volatile components (%) | HGI | True density (g/cm³) | Sum of percentages of the long fibrous structure and the broad-domain structure (%) |
| Example 1 | 5 | 700°C | 3h | 4.8 | 55 | 1.43 | 80 |
| Example 2 | 1 | 700°C | 3h | 3 | 50 | 1.45 | 82 |
| Example 3 | 1 | 900°C | 6h | 2 | 42 | 1.5 | 85 |
| Example 4 | 0.1 | 900°C | 6h | 1.1 | 40 | 1.85 | 86 |
| Comparative example 1 | > 10 | / | / | / | / | / | 50 |
| Comparative example 2 | 0.08 | 900°C | 6h | 0.9 | 38 | 1.85 | 86 |
| Comparative example 3 | 6 | 800°C | 10h | 5.3 | 70 | 1.40 | 55 |
| Comparative example 4 | 6 | 1000°C | 7h | 0.8 | 38 | 1.82 | 85 |
| Comparative example 5 | 1 | 1000°C | 3h | 0.8 | 38 | 1.90 | 89 |
| Comparative example 6 | 1 | 450°C | 3h | 8 | 90 | 1.32 | 52 |

The modified petroleum coke material provided in examples 1-4 and comparative examples 1-6 or the unmodified petroleum coke material (comparative example 1) are raw materials for preparing a graphite negative electrode material. A preparing process is in the following.
(1) The modified green coke material is crushed to obtain a crushed modified green coke material with D50 of 15µm.
(2) The crushed modified green coke material is graded, and then a graphitization treatment is performed on the crushed modified green coke material at a temperature of 3000°C.

By crushing, grading, and performing the graphitization treatment in sequence on the modified petroleum coke material provided in examples 1-4 and comparative examples 1-6 or the unmodified petroleum coke material (comparative example 1), the graphite negative electrode material is obtained.

The graphite negative electrode material provided in examples 1-4 and comparative examples 1-6 is used to prepare a button cell. A gram capacity of the button cell is tested by charging and discharging at a constant current of 1C to a cut-off voltage in a range of 0.005V ~ 2V at room temperature. A charging window is a rate range at which lithium precipitation will not occur on the negative electrode plate of the button cell when charged to 100% SOC at different rates (1C, 2C, 3C, 4C, 5C, 6C). The result is illustrated in Table 2.

**Table 2**

| | Gram capacity (mAh/g) | Charging windows (C) |
|---|---|---|
| Example 1 | 354.0 | 1-6 |
| Example 2 | 354.4 | 1-6 |
| Example 3 | 355.3 | 1-6 |
| Example 4 | 355.8 | 1-5 |
| Comparative example 1 | 350.2 | 1-6 |
| Comparative example 2 | 355.1 | 1-3 |
| Comparative example 3 | 352.3 | 1-6 |
| Comparative example 4 | 355.2 | 1-3 |
| Comparative example 5 | 355.4 | 1-3 |
| Comparative example 6 | 351.2 | 1-6 |

As known from the results of example 1 and example 4, a true density higher than 1.5g/cm³ and a percentage of the volatile components lower than 2% are not conducive to improving the fast charge performance of the graphite negative electrode material obtained from a graphitized modified green coke material.

As known from the results of example 1 and comparative examples 2-4, in the process of preparing the modified green coke material, the green coke particles that are too small (smaller than 0.1mm) or too large (larger than 5mm) before the low-temperature heat treatment will not lead to a modified green coke material with a sum of percentages of the long fibrous structure and the broad-domain structure in a range of 55 ~ 99% and a percentage of the volatile components in a range of 1% ≤ volatile components < 5%, and thus failing to improve the gram capacity and the fast charge performance of the graphite negative electrode material obtained from the graphitized modified green coke material.

As known from the results of example 1, comparative example 5, and comparative example 6, in the process of preparing the modified green coke material, even if D50 of the green coke particles is in a range of 0.1 ~ 5mm, the gram capacity of the graphite negative electrode material obtained from the graphitized modified green coke material will not be significantly improved if the temperature is too low. However, the fast charge performance of the graphite negative electrode material obtained from the graphitized modified green coke material will be affected if the temperature is too high.

It can be concluded from the results of example 1 and comparative examples 2-6 that, in the process of preparing the modified green coke material, the modified green coke material provided in the disclosure can only be obtained when D50 of the green coke particles, the temperature of the low-temperature heat treatment, and the period of the low-temperature heat treatment are all satisfied and provide a joint effect. In this case, the gram capacity of the graphite negative electrode material prepared subsequently can be improved.

### Examples 5-9

A modified pitch coke material is provided in examples 5-9. Volatile components, an HGI, a true density, and a sum of percentages of a long fibrous structure and a broad-domain structure in a polarized microstructure of the modified pitch coke material are as illustrated in Table 3.

A method for preparing the modified pitch coke material is also provided in examples 5-9. According to the method provided in detailed description, an oxygen content in the low-temperature heat treatment is less than 500ppm and a percentage of the volatile components in a raw pitch coke material is 6%. Other parameters are as illustrated in Table 3.

### Comparative example 7

In comparative example 7, no treatment will be performed on the raw pitch coke material.

### Comparative examples 8-10

A modified pitch coke material is provided in comparative examples 8-10. Volatile components, an HGI, a true density, and a sum of percentages of a long fibrous structure and a broad-domain structure in a polarized microstructure of the modified pitch coke material are as illustrated in Table 1.

A method for preparing the modified pitch coke material is also provided in comparative examples 8-10. According to the method provided in detailed description, an oxygen content in the low-temperature heat treatment is less than 500ppm and a percentage of the volatile components of the raw pitch coke material is 10%. Other parameters are as illustrated in Table 3.

**Table 3**

| Pitch coke | Preparation parameter | | | Modified pitch coke | | | |
|---|---|---|---|---|---|---|---|
| | D50 of the green coke particles (mm) | Temperature of the heat treatment (°C) | Period of the heat treatment (h) | Volatile components (%) | HGI | True density (g/cm³) | Sum of percentages of the long fibrous structure and the broad-domain structure (%) |
| Example 5 | 5 | 730°C | 2h | 4.9 | 50 | 1.41 | 67 |
| Example 6 | 5 | 730°C | 3h | 4 | 40 | 1.43 | 74 |
| Example 7 | 1 | 730°C | 3h | 2 | 35 | 1.46 | 80 |
| Example 8 | 1 | 900°C | 6h | 1.8 | 30 | 1.85 | 83 |
| Example 9 | 0.1 | 900°C | 6h | 1.2 | 28 | 1.87 | 85 |
| Comparative example 7 | > 10 | / | / | / | / | / | 45 |
| Comparative example 8 | 6 | 800°C | 10h | 5.2 | 60 | 1.39 | 55 |
| Comparative example 9 | 5 | 450°C | 3h | 6 | 53 | 1.43 | 58 |
| Comparative example 10 | 5 | 1000°C | 3h | 0.9 | 25 | 1.89 | 85 |

The modified pitch coke material provided in examples 5-9 and comparative examples 7-10 or the unmodified pitch coke material (comparative example 1) are raw materials for preparing a graphite negative electrode material. A preparing process is in the following.
(1) The modified green coke material is crushed to obtain a crushed modified green coke material with D50 of 15µm.
(2) The crushed modified green coke material is graded, and then a graphitization treatment is performed on the crushed modified green coke material at a temperature of 3000°C.

By crushing, grading, and performing the graphitization treatment in sequence on the modified pitch coke material provided in examples 5-9 and comparative examples 7-10 or the unmodified pitch coke material (comparative example 1), the graphite negative electrode material is obtained.

The graphite negative electrode material provided in examples 5-9 and comparative examples 7-10 is used to prepare a button cell. A gram capacity of the button cell is tested by charging and discharging at a constant current of 1C to a cut-off voltage in a range of 0.005V ~ 2V at room temperature. A charging window is a rate range at which lithium precipitation will not occur on the negative electrode plate of the button cell when charged to 100% SOC at different rates (1C, 2C, 3C, 4C, 5C, 6C). The result is illustrated in Table. 4.

**Table 4**

| | Gram capacity (mAh/g) | Charging windows (C) |
|---|---|---|
| Example 5 | 352.1 | 1-6 |
| Example 6 | 353.3 | 1-6 |
| Example 7 | 353.5 | 1-6 |
| Example 8 | 353.6 | 1-5 |
| Example 9 | 353.9 | 1-5 |
| Comparative example 7 | 348.0 | 1-6 |
| Comparative example 8 | 350.2 | 1-6 |
| Comparative example 9 | 351.0 | 1-6 |
| Comparative example 10 | 353.8 | 1-3 |

As known from the results of example 5, example 7, and example 8, a true density higher than 1.5g/cm³ and a percentage of the volatile components lower than 2% are not conducive to improving the fast charge performance of the graphite negative electrode material obtained from a graphitized modified green coke material.

As known from the results of example 5 and comparative example 7, a short fibrous structure of the raw green coke material cannot be further developed into a long fibrous structure if no modified treatment is performed on the raw green coke material, which will not lead to an improvement of the gram capacity of the graphite negative electrode material obtained from the graphitized modified green coke material.

As known from the results of example 1 and comparative examples 8-10, in the process of preparing the modified green coke material, the raw green coke material can only be modified when the temperature of the low-temperature heat treatment, the period of the low-temperature heat treatment, and D50 of the green coke particles are all satisfied and provide a joint effect. In this case, the gram capacity of the graphite negative electrode material can be improved. However, the growth of green coke crystals may be affected if only one of the conditions is satisfied, and thus the gram capacity of the graphite negative electrode material obtained from the graphitized modified green coke material cannot be improved.

### Examples 10-13

A modified needle coke material is provided in examples 10-13. Volatile components, an HGI, a true density, and a sum of percentages of a long fibrous structure and a broad-domain structure in a polarized microstructure of the modified needle coke material are as illustrated in Table 3.

A method for preparing the modified needle coke material is also provided in examples 10-13. According to the method provided in detailed description, an oxygen content in the low-temperature heat treatment is less than 500ppm and a percentage of the volatile components of a raw needle coke material is 6%. Other parameters are as illustrated in Table 5.

### Comparative example 11

In comparative example 11, no treatment will be performed on the raw needle coke material.

### Comparative examples 12-13

A modified needle coke material is provided in comparative examples 12-13. Volatile components, an HGI, a true density, and a sum of percentages of a long fibrous structure and a broad-domain structure in a polarized microstructure of the modified needle coke material are as illustrated in Table 1.

A method for preparing the modified needle coke material is also provided in comparative examples 12-13. According to the method provided in detailed description, an oxygen content in the low-temperature heat treatment is less than 500ppm and a percentage of the volatile components of the raw needle coke material is 10%. Other parameters are as illustrated in Table 5.

**Table 5**

| Needle coke | Preparation parameter | | | Modified needle coke | | | |
|---|---|---|---|---|---|---|---|
| | D50 of the green coke particles (mm) | Temperature of the heat treatment (°C) | Period of the heat treatment (h) | Volatile components (%) | HGI | True density (g/cm³) | Sum of percentages of the long fibrous structure and the broad-domain structure (%) |
| Example 10 | 5 | 750°C | 3h | 3 | 40 | 1.45 | 84 |
| Example 11 | 1 | 750°C | 3h | 2.4 | 30 | 1.47 | 90 |
| Example 12 | 1 | 900°C | 6h | 1.4 | 20 | 2.00 | 93 |
| Example 13 | 0.1 | 900°C | 6h | 1 | 20 | 2.00 | 95 |
| Comparative example 11 | > 10 | / | / | / | / | / | 61 |
| Comparative example 12 | 10 | 550°C | 2h | 5.3 | 58 | 1.38 | 63 |
| Comparative example 13 | 0.05 | 900°C | 6h | 0.7 | 18 | 2.05 | 95 |

The modified needle coke material provided in examples 10-13 and comparative examples 11-12 or the unmodified needle coke material (comparative example 1) are raw materials for preparing a graphite negative electrode material. A preparing process is in the following.
(1) The modified green coke material is crushed to obtain a crushed modified green coke material with D50 of 15µm.
(2) The crushed modified green coke material is graded, and then a graphitization treatment is performed on the crushed modified green coke material at a temperature of 3000°C.

By crushing, grading, and performing the graphitization treatment in sequence on the modified needle coke material provided in examples 10-13 and comparative examples 11-13 or the unmodified needle coke material (comparative example 1), the graphite negative electrode material is obtained.

The graphite negative electrode material provided in examples 10-13 and comparative examples 11-12 is used to prepare a button cell. A gram capacity of the button cell is tested by charging and discharging at a constant current of 1C to a cut-off voltage in a range of 0.005V ~ 2V at room temperature. A charging window is a rate range at which lithium precipitation will not occur on the negative electrode plate of the button cell when charged to 100% SOC at different rates (1C, 2C, 3C, 4C, 5C, 6C). The result is illustrated in Table. 6.

**Table 6**

| | Gram capacity (mAh/g) | Charging windows (C) |
|---|---|---|
| Example 10 | 362.1 | 1-6 |
| Example 11 | 362.5 | 1-6 |
| Example 12 | 363.1 | 1-5 |
| Example 13 | 363.5 | 1-5 |
| Comparative example 11 | 354.0 | 1-6 |
| Comparative example 12 | 354.5 | 1-5 |
| Comparative example 13 | 363.8 | 1-3 |

As known from the results of example 10, example 12, and example 13, a true density higher than 1.5g/cm³ and a percentage of the volatile components lower than 2% are not conducive to improving the fast charge performance of the graphite negative electrode material obtained from a graphitized modified green coke material.

As known from the results of example 10 and comparative example 11, a short fibrous structure of the raw green coke material cannot be further developed into a long fibrous structure if no modified treatment is performed on the raw green coke material, and the volatile components in the raw green coke material cannot escape, which will not lead to an improvement of the gram capacity of the graphite negative electrode material obtained from the graphitized modified green coke material.

As known from Table 1 to Table 6, in the process of preparing the modified green coke material provided in the disclosure, the modified green coke material can only be obtained when D50 of the green coke particles, the temperature of the low-temperature heat treatment, and the period of the low-temperature heat treatment are all satisfied. In the case where a percentage of the volatile components is in a range of 2% ≤ volatile components < 5%, and the true density of the modified green coke material is in a range of 1.4 ~ 1.5g/cm³, the agglomeration may be difficult to occur during a subsequent preparation of the graphite negative electrode material. As a result, the graphite negative electrode material will have a better performance and a higher gram capacity.

In summary, in the modified green coke material provided in the disclosure, the volatile components are effectively reduced, and the light components are further excluded, thereby eliminating the self-bonding property of raw materials. In this case, further agglomeration will not occur during the subsequent heat treatment for preparing the graphite negative electrode material, and the long fibrous structure and the broad-domain structure are increased. Using the modified green coke material to prepare the graphite negative electrode material can effectively improve the graphitization degree, the gram capacity, and the compaction density of the graphite negative electrode material, thus comprehensively improving the performance of the graphite negative electrode material. In the disclosure, by adjusting D50 of the green coke particles, the temperature of the low-temperature heat treatment, and the period of the low-temperature heat treatment in the preparing process, a modified green coke material with a percentage of the volatile components in a range of 1% ≤ volatile components < 5% and a true density in a range of 1.4 ~ 2g/cm³ is obtained. A cell using the graphite negative electrode material prepared from the modified green coke material as a negative electrode has a gram capacity greater than 352.1mAh/g at 1C and a charging windows above 1-5C, which is indicated by the absence of lithium precipitation at the negative electrode of the cell charged to 100% SOC at different rates (1C, 2C, 3C, 4C, 5C, 6C).

It is to be understood that the above embodiments are merely specific embodiments of the disclosure and are not intended to limit the scope of protection of the disclosure. Those of ordinary skill in the art should understand that, modifications and variations made by those of ordinary skill in the art within the technical scope of the disclosure shall fall within the protection scope of the disclosure.

## Claims

1. A modified green coke material, wherein a sum of percentages of a long fibrous structure and a broad-domain structure in a polarized microstructure of the modified green coke material is in a range of 55 ~ 99%, and a percentage of volatile components in the modified green coke material is in a range of 1% ≤ volatile components < 5%.

2. The modified green coke material of claim 1, wherein the modified green coke material has a true density in a range of 1.4 ~ 2g/cm³, preferably 1.4 ~ 1.5g/cm³.

3. The modified green coke material of claim 1 or 2, wherein the modified green coke material has a hardgrove grindability index (HGI) in a range of 20 ~ 100.

4. The modified green coke material of any one of claims 1-3, wherein the percentage of volatile components in the modified green coke material is in a range of 2% ≤ volatile components < 5%.

5. A method for preparing a modified green coke material, comprising:
performing a treatment on a raw green coke material to obtain green coke particles with D50 in a range of 0.1 ~ 5mm, and then performing a low-temperature heat treatment to obtain the modified green coke material.

6. The method for preparing the modified green coke material of claim 5, wherein the raw green coke material comprises any one or at least two selected from green petroleum coke, green needle coke, green pitch coke, and mesophase coke.

7. The method for preparing the modified green coke green coke material of claim 5 or 6, wherein the treatment comprises screening and/or crushing.

8. The method for preparing the modified green coke green coke material of any one of claims 5-7, wherein D50 of the green coke particles is in a range of 0.3 ~ 3.0mm.

9. The method for preparing the modified green coke material green coke of any one of claims 5-8, wherein the low-temperature heat treatment is performed at a temperature in a range of 500~900°C, and the low-temperature heat treatment is performed for a period of 2 ~ 6h.

10. The method for preparing the modified green coke green coke material of any one of claims 5-9, wherein in the low-temperature heat treatment, an oxygen content ≤ 500ppm.

11. A method for preparing a modified green coke material, comprising:
crushing a raw green coke material to obtain green coke particles with D50 in a range of 0.1 ~ 5mm; and
performing, in an environment with an oxygen content ≤ 500ppm, a low-temperature heat treatment at a temperature of 500~900°C for 2 ~ 6h to obtain the modified green coke material.

12. A graphite negative electrode material, wherein the graphite negative electrode material is obtained by performing a graphitization treatment on the modified green coke material of any one of claims 1-4.

13. A lithium-ion cell, comprising the graphite negative electrode material of claim 12.

14. A method for preparing a graphite negative electrode material using the modified green coke material of any one of claims 1-4, comprising:
(1) crushing the modified green coke material to obtain a crushed modified green coke material with D50 in a range of 8 ~ 20µm; and
(2) performing a graphitization treatment on the crushed modified green coke material at a temperature in a range of 2500 ~ 3500°C.

15. A method for preparing a graphite negative electrode material, comprising:
(1) performing a treatment on a raw green coke material to obtain green coke particles with D50 in a range of 0.1 ~ 5mm, and then performing a low-temperature heat treatment to obtain a modified green coke material;
(2) crushing the modified green coke material to obtain a crushed modified green coke material with D50 in a range of 8 ~ 20µm; and
(3) performing a graphitization treatment on the crushed modified green coke material at a temperature in a range of 2500 ~ 3500°C.
